# EUROPEAN PATENT APPLICATION

(11) **EP 4 779 866 A1**
(43) Date of publication of application: **22.07.2026**
(21) Application number: 24865005.3
(22) Date of filing: 27.05.2024
(51) Int. Cl.: H03F 3/217, H03F 1/26

(54) **SWITCHING AMPLIFIER**

(30) Priority: 12.09.2023 JP 2023147600
(71) Applicant: Kyosan Electric Mfg. Co., Ltd., Tsurumi-ku, Yokohama-shi Kanagawa 230-0031 (JP)
(72) Inventor: KUNITAMA Hiroshi, Yokohama-shi, Kanagawa 230-0031 (JP); YOSHIDA Takuya, Yokohama-shi, Kanagawa 230-0031 (JP)
(74) Representative: Hoffmann Eitle
(86) International application number: PCT/JP2024/019435
(87) International publication number: WO 2025/057497

(57) **Abstract**

A switching amplifier of the present invention is a push-pull switching amplifier having a narrowband filter on its output side, and includes a partial resonance circuit for suppressing a first surge voltage caused by a square wave, and an LCR series resonator for suppressing a second surge voltage caused by a harmonic frequency component, so that a drain-source voltage Vds of the switching element has a waveform in a trapezoidal shape. As a result, the first surge voltage caused by the square wave and the second surge voltage caused by the harmonic frequency component are suppressed, and the frequency characteristics of the output from the switching amplifier are widened and the output frequency is made variable.

## Description

### [TECHNICAL FIELD]

The present invention relates to a switching amplifier employing a switching mode, such as class-D, class-E, class-F, inverse class-F, and class-EF amplifiers, in particular relates to a switching amplifier suitable for a variable frequency RF generator which can vary an output frequency to a wideband frequency.

### [BACKGROUND ART]

Switching amplifiers generate a square wave by switching operation, and modulate a pulse width of the generated square wave according to an input signal level to thereby amplify an output. There is a circuit configuration for the switching amplifiers that operates two switching elements in opposite phases, and alternately performs actions of sending out and drawing in an electric current to increase an output current. Such a push-pull circuit can be applied to obtain a large-capacity power output.

In a push-pull type class-D switching amplifier, the voltage waveform of a drain-source voltage generated by the switching operation is square waveshape. The square waveshape of the voltage waveform of the drain-source voltage is distorted (occurrence of surge) due to a leakage inductance. It is known that a coupling factor of an output transformer is increased to reduce the leakage inductance in order to make the waveform of the drain-source voltage to be the square waveshape (see Non-Patent Literature 1).

### [CITATION LIST]

### [PATENT LITERATURE]

[Non-Patent Literature 1] Application Note 1812 "13.56 MHz, Class-D Push-Pull, 2KW RF Generator with Microsemi DRF1300 Power MOSFET Hybrid" by Gui Choi, Microsemi PPG, September, 2011.

### [SUMMARY OF THE INVENTION]

### [PROBLEMS TO BE SOLVED BY THE INVENTION]

The switching amplifiers have a drawback that a leakage inductance of the output transformer or others generates a surge voltage (hereinafter referred to as first surge voltage) in the switching operation for generating a square wave.

An output waveform from the output transformer of the switching amplifier includes a fundamental frequency component as well as harmonic frequency components. As a harmonic counter measure to remove the harmonic frequency components from the output, a narrowband filter, such as LPF (low-pass filter), may be provided on a secondary side of the output transformer. The narrowband filter passes the fundamental frequency component while preventing the harmonic frequency components from passing. The harmonic frequency components are reflected by the narrowband filter and returned to a switching element side. The harmonic frequency components thus returned act on a switching element as a surge voltage (hereinafter referred to as second surge voltage). In a switching amplifier in a VHF band, which uses switching elements over a wide frequency band of several-hundred MHz, such as LDMOS, the frequency of harmonic frequency components reflected and returned by the narrowband filter is also within the frequency band of the switching element and thus is influenced by the surge voltage, resulting in more significant problem of the second surge voltage.

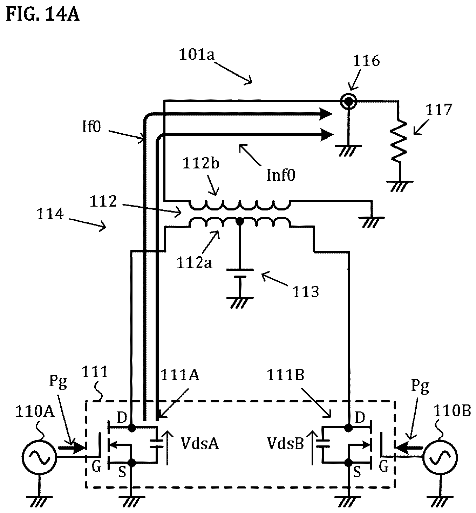

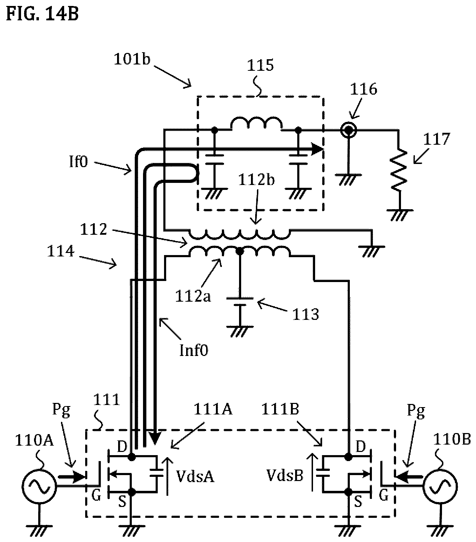

Figure 14 illustrates the second surge voltage of the harmonic frequency components. As a circuit example of a push-pull type class-D switching amplifier, FIG. 14A shows a circuit example having no narrowband filter and FIG. 14B shows a circuit example having a narrowband filter.

A switching amplifier 101a shown in FIG. 14A includes a switching unit 111 that includes two switching elements 111A and 111B, an output transformer 112 that is connected between drains of the switching elements 111A and 111B, and a DC power source 113 that is connected to a midtap of a primary winding 112a of the output transformer 112. The switching amplifier 101a forms a push-pull circuit 114 by alternately switching the switching elements 111A and 111B with gate signals Pg in opposite phases output from signal sources 110A and 110B. The push-pull circuit 114 enables the transmission of an electric current to the secondary winding 112b of the output transformer 112. The transmitted current is fed to a load 117 that is connected to an output end 116.

In the switching amplifier 101a in FIG. 14A, a switching operation conducted on drain-source voltages VdsA and VdsB respectively in the switching elements 111A and 111B transmits a square wave If0 and an electric current InfO of harmonic frequency components are transmitted to the load 117 and they are consumed therein. In this configuration, an output waveform is also in a square shape, and it is therefore not suitable for a high-frequency power supply to be applied to a semiconductor manufacturing apparatus that is required to output sinusoidal waveforms.

On the other hand, in the switching amplifier 101b in FIG. 14B, a narrowband filter 115 is provided on a secondary side of the output transformer 112 so that an output waveform can be a sinusoidal shape. The configuration having the narrowband filter 115 can obtain a sinusoidal output voltage, but cannot keep the waveforms of the drain-source voltages VdsA and VdsB in the square shape. The inventors of the present application found that a cause of the failure to keep the square waveform is that the current InfO of the harmonic frequency components in the drain-source voltages VdsA and VdsB is reflected by the narrowband filter 115 and returned to the switching elements 111A and 111B.

VHF amplifiers use switching elements, such as LDMOSs, which have a wide frequency bandwidth of their own to cover a wide frequency range. Thus, in order to avoid the harmonic frequency components from being returned by reflection, the narrowband filter cannot be provided actively on the secondary side of the output transformer in the switching amplifiers having wideband output frequency characteristics. It is therefore not possible to achieve both wide band output and sinusoidal output waveform.

Consequently, in the VHF amplifiers, switching operation generates two surge voltages that a first surge voltage due to a leakage inductance of the output transformer or others and a second surge voltage due to the harmonic frequency components reflected by the narrowband filter, and these surge voltages become factors that prevent widening of output frequencies in RF generators by using the switching amplifiers.

In order to obtain a stable output even in a case where a switching amplifier has its output frequency characteristics widened and an output frequency can be made variable, the waveform of a drain-source voltage Vds of a switching element needs to be trapezoidal in which a first surge voltage caused by a square wave and a second surge voltage caused by harmonic frequency components are suppressed.

An object of the present invention is to solve the above-described problems, and suppress the surge voltages that are the first surge voltage caused by the square wave and the second surge voltage caused by the harmonic frequency components so that the output frequency characteristics of the switching amplifier are widened and the output frequency can be made variable.

### [MEANS FOR SOLVING THE PROBLEM]

A switching amplifier according to the present invention is a push-pull switching amplifier having a narrowband filter on its output side, including a partial resonance circuit that suppresses a first surge voltage due to a square wave and an LCR series resonator that suppresses a second surge voltage due to harmonic frequency components. A drain-source voltage Vds of a switching element has a waveform that is a trapezoidal shape, so that output frequency characteristics of the switching amplifier are widened and an output frequency can be made variable.

### (Drain-source voltage Vds with trapezoidal waveform)

The waveform in the trapezoidal shape is a sloped waveform in an interval where a predetermined time width is required during a rise and a fall of a voltage, and a peak value of the waveform is maintained constant in an interval from the rise of the voltage to its fall.

The sloped waveform suppresses a surge voltage and harmonic frequency components of the drain-source voltage Vds of the switching element that are generated by the rise and the fall of the voltage. With the waveform with the peak value being maintained constant, the drain-source voltage Vds is constant even if the output frequency is variable and is swept on the wideband, so that an output gain can be maintained constant.

### (Configuration of switching amplifier)

The switching amplifier according to the present invention includes various constituent elements:
(a) a transformer-coupled push-pull circuit that consists of a pair of switching elements alternately switched on and off by using input signals having phases opposite to each other, and a transformer in which a primary winding which inputs output signals of the switching elements and a secondary winding which draws out the output signals are connected on both ends of the transformer and a midtap of the primary winding is connected to an external power supply;
(b) a narrowband filter that is connected to an output end of the secondary winding of the transformer;
(c) a pair of partial resonance circuits that consist of an inductance component on a drain side of each switching element and a capacitance component between the drain and a source of each switching element; and
(d) an LCR series resonator that consists of a series circuit of the inductance and the capacitance, connected between the drains of switching elements.

Each switching element included in the switching amplifier of the present invention can adopt a MOSFET, and for a power MOSFET, an LDMOS or VDMOS having a DMOS structure can be applied.

### (Push-pull circuit)

The push-pull circuit is configured to alternately switch on and off the pair of switching elements by using the input signals in opposite phases. This alternate switching allows each switching element to alternately conduct with the external power supply connected to the midtap of the primary winding of the transformer, and thereby an inductance current flows in the primary winding in the opposite directions alternately. Due to transformer coupling, the inductance current is applied as a load current in the secondary winding of the transformer. The inductance current flowing in the primary winding flows in the opposite directions alternately. The flow of the inductance current on the primary winding part corresponds to sending-out and drawing-in of the current alternately carried out on the secondary winding part, so that the load current transmitted from the primary winding flows in the secondary winding.

The load current induced in the secondary winding includes a fundamental frequency component and harmonic frequency components depending on a switching frequency of the switching element. The load current includes only odd harmonic frequency components because even harmonic components cancel each other due to the characteristics of the push-pull circuit.

### (Narrowband filter)

The narrowband filter is configured to pass the fundamental frequency component included in the load current in the secondary winding but to prevent the harmonic frequency components from passing. The harmonic frequency components are reflected by the narrowband filter and returned to the switching element. The harmonic frequency components returned to the switching element become surge voltage (second surge voltage) for the switching element.

### (LCR series resonator)

The LCR series resonator consists of a series circuit formed of the inductance, the capacitance and a resistance, and is connected between the drains of the pair of switching elements. The resonance frequency of the series circuit is set to match the frequency of the harmonic frequency components of the load current.

### (Parallel connection of LCR series resonator)

The LCR series resonator is configured by parallel-connection of multiple series circuits having different resonant frequencies so that the frequency bandwidth of the harmonic frequency components in the load current can be widened.

The LCR series resonator configured by connecting two series circuits in parallel includes a first series circuit that have a resonance frequency on the lower frequency side than a harmonic frequency n·f0 of the high-frequency output and a second series circuit that have a resonance frequency on the higher frequency side than the harmonic frequency n·f0 of the high-frequency output respectively with respect to a fundamental frequency f0 of a high-frequency output from the secondary side of the transformer.

In a case where the LCR series resonator consists of multiple series circuits connected in parallel, the number of the parallel-connected series circuits is not limited to two and may be an arbitrary number.

### (Suppression of second surge voltage by LCR series resonator)

The harmonic frequency components reflected by the narrowband filter flow to a ground through the LCR series resonator and a switching element in an ON state. In this case, the harmonic frequency components are consumed and damped by the resistance of the series circuit. The damping of the harmonic frequency components suppresses the second surge voltage due to the harmonic frequency components applied to the switching element. The suppression of the second surge voltage prevents fluctuation in the peak value of the drain-source voltage Vds of the switching element, and thereby the peak value remains almost constant.

### (Partial resonance circuit)

The partial resonance circuit consists of an inductance component on the drain side of the switching element and a capacitance component between the drain and the source of the switching element. The partial resonance circuit is formed in each of the pair of switching elements.

An inductance component (Ls) of each partial resonance circuit is any of a series inductance (Ls1) connected in series between the switching element and one end of the transformer or a leakage inductance (Lleak) of the output transformer or a wiring inductance (Lline) between the switching element and one end of the transformer, or any combinations of them.

A capacitance component (Ctotal) included in each partial resonance circuit is an output parasitic capacitance (Coss) of the switching element or a total capacitance of the output parasitic capacitance (Coss) of the switching element and an additional capacitance (Cp) connected to the switching element in parallel.

When the switching element changes from the ON state into an OFF state, a charge of the capacitance component (Ctotal) that has been discharged in the ON state is charged by first resonance produced by partial resonance applying a primary current in the transformer. During charging, the drain-source voltage Vds of the switching element increases with a time constant τr defined by the inductance component (Ls) and the capacitance component (Ctotal).

On the other hand, when the switching element changes from the OFF state into the ON state, the charge of the capacitance component (Ctotal) that has been charged in the OFF state is discharged by second resonance produced by the partial resonance in the primary current in the transformer. During discharging, the drain-source voltage Vds of the switching element decreases with a time constant τf defined by the inductance component (Ls) and the capacitance component (Ctotal).

During a dead time period, the capacitance components (Ctotal) of the two switching elements are connected in series to form the capacitance component (Ctotal) in the first resonance. By contrast, the capacitance component (Ctotal) of only one switching element forms the capacitance component (Ctotal) in the second resonance, so that the time constant τr of the first resonance is smaller than the time constant τf of the second resonance, causing the voltage to rise faster. The first resonance and the second resonance make the drain-source voltage Vds to have a trapezoidal waveform.

### (Suppression of first surge voltage by partial resonance circuit and LCR series resonator)

Since the partial resonance applying the primary current in the transformer causes the increase or decrease in the drain-source voltage Vds of the switching element with the time constant τr, τf during the dead time period, the surge voltage generated in the drain-source voltage Vds is suppressed.

Furthermore, during periods other than the dead time, the charging current in the first resonance and the discharging current in the second resonance due to the partial resonance flow between two drains through the LCR series resonator. The charging and discharging currents flowing through the LCR series resonator are consumed and damped by a resistance Rr of the LCR series resonator. Since the charging and discharging currents increase or decrease with the time constants τr, τf due to the partial resonance during the periods other than the dead time and are consumed and damped by the LCR series resonator, the generation of the first surge voltage in the drain-source voltage Vds is prevented.

In this way, the first surge voltage caused by the square wave is suppressed by the partial resonance circuit and the LCR series resonator, thereby making the drain-source voltage Vds to have a trapezoidal waveform.

### (Resonance frequency and bandwidth for partial resonance circuit)

The resonance frequency of a pair of partial resonance circuits exists in a range from fundamental frequency f0 to third harmonic frequency 3·f0 of a high-frequency output from the secondary side of the transformer, the resonance circuits decrease an impedance within a frequency range in which an impedance is higher and also set predetermined time constants on the rising edge and the falling edge of the drain-source voltage Vds of an LDMOS.

### (Resonance frequency and bandwidth for LCR series resonator)

Provided that the fundamental frequency of the high-frequency output from the secondary side of the transformer is f0, the resonance frequency of the LCR series resonator is harmonic frequency n·f0 (where n is an integer), and a bandwidth of the resonance frequency is set within a frequency range of (n·f0-min to n·f0-max) according to a variable frequency range (f0-min to f0-max) of the fundamental frequency f0.

### (Effect by switching amplifier of the present invention)

The switching amplifier according to the present invention suppresses the surge voltage, and widens the frequency characteristics of the output from the switching amplifier and makes the output frequency variable, so that the following secondary effects can be achieved.

- It is not necessary to take measures against the leakage from the output transformer.

The prior art document discloses that a coupling factor of an output transformer is increased to reduce a leakage inductance in order to obtain a square waveform for a drain-source voltage, and shows a configuration for reducing the leakage inductance, in which a magnetic core is prepared as the material of the output transformer, and is winded with a stranded wire structure. This is a typical way of increasing the coupling factor and reducing the leakage inductance. Furthermore, there is a method for selecting material with high relative permeability µ for the core material. However, there is a problem of difficulty in designing to withstand continuous outputting of a high output voltage because losses due to the core material increases in proportion to the relative permeability µ.

The present invention can eliminate the need for the core material with the high relative permeability and the stranded wire structure to take measures against the leakage from the output transformer, and can achieve an amplifier capable of continuous outputting of high output power.

In general, even if an air-core output transformer which is coreless with large leakage inductance or a parallel-winding planar transformer which has low coupling factor due to its winding structure is used, a low-pass filter (LPF) can be inserted on the secondary side of the transformer, thereby enabling the implementation of a class-D push-pull amplifier with less output harmonics.

- Since the peak value of the drain-source voltage Vds can be about the same over the entire wideband interval, power gain can be maintained constant.

According to the present invention, since the waveform of the drain-source voltage Vds always has a similar peak value, it is possible to prevent output fluctuation, and thus to prevent power gain fluctuation due to frequency variability, which is accentuated in class-AB and class-C amplifiers, thereby obtaining flat output characteristics.

- Even if the leakage inductance is large, stable trapezoidal Vds waveform can be obtained, thereby achieving wider bandwidth.
- The LPF (low-pass filter) can be inserted on the secondary side of the output transformer, thereby reducing the output harmonics.
- The surge voltage caused by the partial resonance can be suppressed, and the drain-source voltage Vds in the switching can be prevented from exceeding an element withstand voltage of the switching element.

### [EFFECT OF THE INVENTION]

As described above, according to the present invention, the surge voltages that are the first surge voltage caused by the square wave and the second surge voltage caused by the harmonic frequency components can be suppressed so that the frequency characteristics of the output from the switching amplifier are widened and the output frequency can be made variable.

### [BRIEF DESCRIPTION OF THE DRAWINGS]

Figure 1 illustrates a first configuration of a switching amplifier according to the present invention;
Figure 2 illustrates a second configuration of the switching amplifier according to the present invention;
Figure 3A shows a comparison of transmission characteristics between an LCR series resonator and an LC series resonator;
Figure 3B shows an equivalent circuit formed by the LCR series resonator and the LC series resonator;
Figure 4 illustrates a signal in each unit of the switching amplifier according to the present invention;
Figure 5A illustrates an operation example in each section in the switching amplifier according to the present invention;
Figure 5B illustrates an operation example in each section in the switching amplifier according to the present invention;
Figure 6A illustrates an operation example in each section in the switching amplifier according to the present invention;
Figure 6B illustrates an operation example in each section in the switching amplifier according to the present invention;
Figure 7A illustrates an operation example in each section in the switching amplifier according to the present invention;
Figure 7B illustrates an operation example in each section in the switching amplifier according to the present invention;
Figure 8A illustrates an operation example in each section in the switching amplifier according to the present invention;
Figure 8B illustrates an operation example in each section in the switching amplifier according to the present invention;
Figure 9 illustrates a trapezoidal waveform of a drain-source volage of the switching element;
Figure 10 shows a waveform example when a fundamental frequency f0 is 45 MHz;
Figure 11 shows a waveform example when the fundamental frequency f0 is 35 MHz;
Figure 12A illustrates widening of a bandwidth of an output by the LCR series resonator;
Figure 12B illustrates widening of the bandwidth of the output by the LCR series resonator;
Figure 13A is a Smith Chart illustrating a relationship between a frequency band of partial resonance and a frequency band of a high impedance;
Figure 13B is a frequency characteristics diagram illustrating the relationship between the frequency band of the partial resonance and the frequency band of the high impedance;
Figure 14A illustrates a second surge voltage generated by harmonic frequency components; and
Figure 14B illustrates the second surge voltage generated by the harmonic frequency components.

### [BEST MODE FOR CARRYING OUT THE INVENTION]

### (1) Schematic Configuration of Switching Amplifier

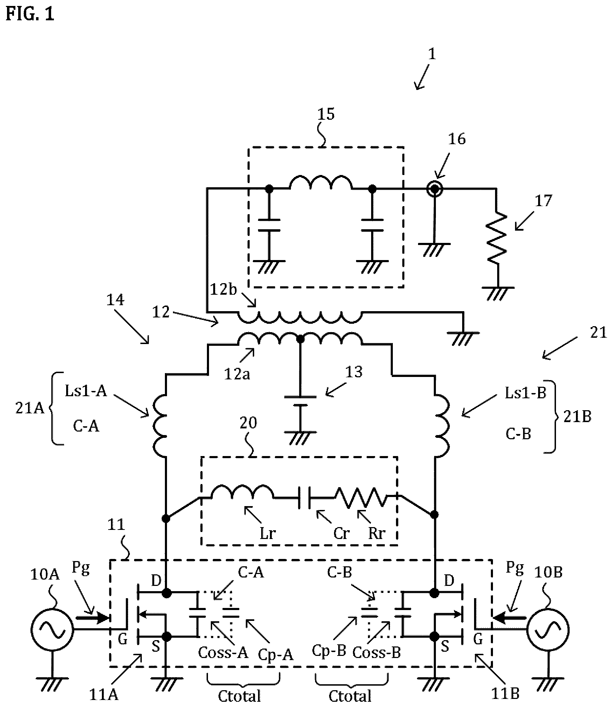

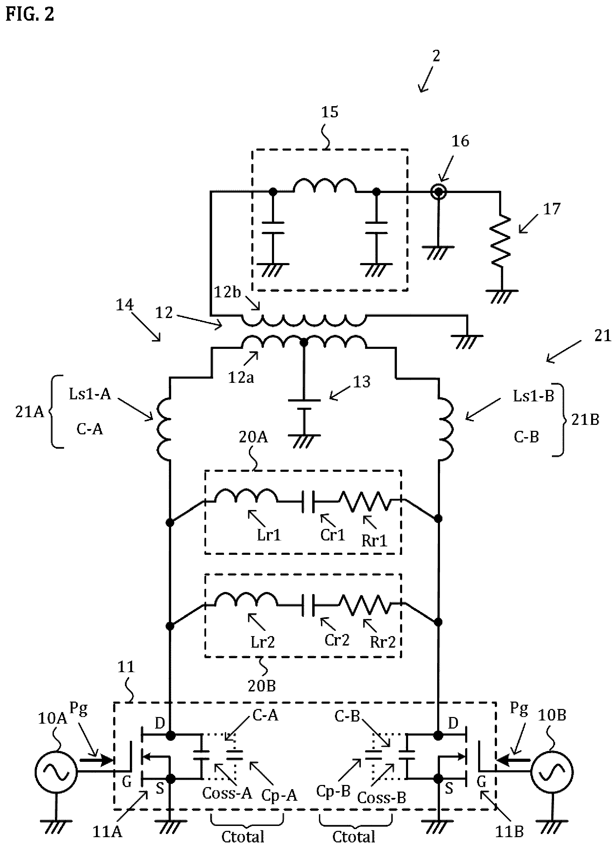

A schematic configuration of a switching amplifier according to the present invention will now be described by referring to FIGS. 1 and 2.

Figure 1 shows a first configuration example that includes one LCR series resonator, and FIG. 2 shows a second configuration example that includes two LCR series resonators which are connected in parallel to each other.

### (1-1: First configuration example)

According to a first configuration example, a switching amplifier 1 includes a switching unit 11, an output transformer 12, an external power supply consisting of a DC power source 13, and a narrowband filter 15, as well as an LCR series resonator 20 and partial resonance circuits 21 (21A, 21B).

The switching unit 11 includes two switching elements. The switching elements employ MOSFETs, and a power MOSFET is applied for a heavy-current type. The power MOSFET employs DMOS, such as LDMOS and VDMOS. In here, the LDMOS will be described as an example of the switching element, and the two switching elements included in the switching unit 11 are indicated by reference letters LDMOS (11A) and LDMOS (11B).

The LDMOS (11A) has a gate terminal to which a gate signal Pg is input from a signal source 10A to switch ON and OFF between a drain terminal and a source terminal which is grounded. Correspondingly, the LDMOS (11B) has a gate terminal to which the gate signal Pg is input from a signal source 10B to switch ON and OFF between the drain terminal and the grounded source terminal. The gate signals Pg from the signal source 10A and the signal source 10B are made to have opposite phases to each other so that outputs from the LDMOS (11A) and the LDMOS (11B) have opposite phases.

The output transformer 12 is connected between the drain terminal of the LDMOS (11A) and the drain terminal of the LDMOS (11B), and the DC power source 13 is connected to a midtap of the output transformer 12, and the outputs from the LDMOS (11A) and the LDMOS (11B) are made to have the opposite phases to thereby constitute a push-pull circuit 14. The push-pull circuit 14 is configured to alternately conduct current send-out and current draw-in in a secondary winding 12b so as to transmit a load current that is an output current.

The narrowband filter 15, such as an LPF, is disposed between the secondary winding 12b of the output transformer 12 and an output terminal 16. The narrowband filter 15 is configured to block a harmonic frequency n·f0 contained in the load current of the output current while passing a fundamental frequency f0 to the output terminal 16.

In the push-pull circuit 14, the harmonic frequency n·f0 flowing in the secondary winding 12b is odd harmonic frequency because even harmonic frequency components cancel one another. Furthermore, a peak value of the harmonic frequency becomes smaller as the order of harmonic becomes higher. Thus, the narrowband filter 15 is designed to have frequency characteristics for blocking a third harmonic frequency 3·f0 as harmonic frequency n·f0 so that the harmonic frequency components can be adequately blocked.

The switching amplifier according to the present invention characteristically includes an LCR series resonator 20 as a configuration to suppress a second surge voltage generated due to the harmonic frequency components contained in the load current of the output current, and also characteristically includes the LCR series resonator 20 and partial resonance circuits 21 (21A, 21B) as a configuration to suppress a first surge voltage generated due to frequency components contained in a drain-source voltage Vds that is an output voltage of the LDMOS that is a switching element.

### (LCR Series Resonator)

The LCR series resonator 20 consists of a series circuit formed by an inductance Lr, a capacitance Cr and a resistance Rr, and is connected between the drain terminals of the LDMOS (11A) and the LDMOS (11B) and also connected in parallel to a primary winding 12a of the output transformer 12.

A resonance frequency of the series circuit of the LCR series resonator 20 is set to match the frequency of a harmonic frequency component of the load current.

In the push-pull circuit, the harmonic frequency components contained in the load current are odd harmonic frequency components, and the peak values of fifth or higher harmonic frequency components are smaller than the peak values of the third harmonic frequency components. Thus, the resonance frequency of the series circuit is approximately 3 times the fundamental frequency f0 and its bandwidth [f0-min, f0-max], and is therefore set around twice to 4 times the frequency, further taking into account a deviation of a resonance constant. The bandwidth f0-min is the lower limit frequency of the load current and the bandwidth f0-max is the upper limit frequency of the load current.

The resistance Rr, which is a resistance component of the series circuit, is set to 0.5 Ω [ohm] to 15 Ω [ohm], by way of example, so as to achieve adequate damping at the center frequency of the third harmonic frequency and produce a damping effect over a wide bandwidth. The setting range of the resistance Rr is such that a resistance value when viewed from the primary side of the output transformer is as large as a load impedance of a fundamental wave.

Provided that a turn ratio of the output transformer is m:n and a primary resistance component and a secondary resistance component are R1 and R2, respectively, there is a relationship R1=(m/n)²·R2. In this relationship, when m=1, n=2 and R2=50 [ohm], for instance, the upper limit value is set to 15 [ohm] because the primary resistance component R1 is 12.5 [ohm]. Furthermore, the lower limit value is set to 0.5 [ohm] because the load impedance suitable for the properties of the LDMOS decreases as the fundamental frequency increases.

The LCR series resonator 20 damps harmonic frequency components that are reflected by the narrowband filter and returned to the LDMOS. Consequently, the peak value of the drain-source voltage of the LDMOS can be maintained to a constant value, and thereby output gain characteristics can be maintained even when the frequency of the load current is swept over the wideband to enable stable output at the wideband.

### (Partial Resonance Circuit)

The partial resonance circuit 21 includes a partial resonance circuit 21A on the LDMOS (11A) side and a partial resonance circuit 21B on the LDMOS (11B) side.

The partial resonance circuit 21A consists of a series circuit that is formed by an inductance component Ls-A on the drain terminal side of the LDMOS (11A) and a capacitance component C-A of the LDMOS (11A).

The inductance component Ls-A is either a series inductance Ls1-A connected in series between the LDMOS (11A) and one end of the output transformer 12, a leakage inductance Lleak of the output transformer 12 or a wiring inductance Lline-A between the LDMOS (11A) and one end of the output transformer 12, or a combination of any of them. The series inductance Ls1-A is connected according to the resonance frequency of the partial resonance circuit 21A, as appropriate.

The capacitance component C-A of the LDMOS (11A) can use a parasitic capacitance Coss-A of the LDMOS (11A), as well as a total capacitance Ctotal-A of an additional capacitance Cp-A connected in parallel between the drain terminal and the source terminal of the LDMOS (11A) and a parasitic capacitance Coss-A.

As with the partial resonance circuit 21A, the partial resonance circuit 21B consists of a series circuit that is formed by a series inductance component Ls-B on the drain terminal side of the LDMOS (11B) and a capacitance component C-B of the LDMOS (11B).

The inductance component Ls-B is either a series inductance Ls1-B connected in series between the LDMOS (11B) and the other end of the output transformer 12, the leakage inductance Lleak of the output transformer 12 or a wiring inductance Lline-B between the LDMOS (11B) and the other end of the output transformer 12, or a combination of any of them. The series inductance Ls1-B is connected according to the resonance frequency of the partial resonance circuit 21B, as appropriate

The capacitance component C-B of the LDMOS (11B) can use a parasitic capacitance Coss-B of the LDMOS (11B), as well as a total capacitance Ctotal-B of an additional capacitance Cp-B connected in parallel between the drain terminal and the source terminal of the LDMOS (11B) and a parasitic capacitance Coss-B. The additional capacitances Cp-A, Cp-B may be either a lumped constant or a distributed constant.

The resonant frequencies of the partial resonance circuits 21A and 21B decrease impedances in a frequency range where the impedances are increased by the partial resonance circuits within the range from the fundamental frequency f0 to the third harmonic frequency 3·f0 of the high-frequency output from the secondary side of the output transformer 12, and set predetermined time constants for the rise and the fall of the drain-source voltage Vds of the LDMOS.

The partial resonance circuit tilts the waveform of the drain-source voltage Vds on the rising edge and the falling edge of the voltage so as to have a trapezoidal shape with predetermined time widths, thereby suppressing high-frequency components that are generated on the rising edge and the falling edge. At this time, the partial resonance circuits 21A and 21B partially resonate near the frequency range where the impedance between the drains is high to thereby decrease the impedance.

### (Series Resonator and Partial Resonance Circuit)

The series resonator and the partial resonance circuit have the different resonant frequencies used for the suppression by resonance. The resonance frequency of the series resonator decreases the harmonic frequency components contained in a high-frequency output to suppress the surge voltage. On the other hand, the resonance frequency of the partial resonance circuit obtains the drain-source voltage Vds with the trapezoidal waveform having rising and falling characteristics with slopes to decrease the impedance at the frequency at which the impedance is high, thereby suppressing the surge voltage.

When the series resonator resonates, the impedance is composed of the resistance Rr only, and the resistance Rr forms a parallel damping circuit together with the inductance component Ls and the capacitance component C of the partial resonance circuit. A damping rate ζ of this parallel damping circuit is ζ=(1/(2·Rr)) ·(Ls/C), and the smaller the resistance Rr, the larger the damping rate ζ becomes, leading to the increase in a damping effect.

The resonance frequency of the series resonator is set so as to have a harmonic frequency bandwidth [n·f0min to n·f0max] according to a variable frequency range [f0min to f0max] when the fundamental frequency f0 is varied. Thus, when the frequency of the high-frequency output is changed, a plurality of resonance frequencies is set according to the changed frequency.

On the other hand, the resonance frequency of the partial resonance circuit is set such that the drain-source voltage Vds has the trapezoidal waveform with tilted portions in the frequency range close to the frequency at which the impedance is high. The inductance component Ls and the capacitance component C are set according to the resonance frequency thus set. The frequency range in which the resonance frequency is set does not fluctuate significantly even when the frequency of the high-frequency output is changed. Consequently, even when the frequency of the high-frequency output is changed, it is not necessary to change the resonance frequency according to the changed frequency, and only one resonance frequency needs to be set.

### (1-2: Second configuration example)

A second configuration example of the switching amplifier 1 includes, as with the first configuration example, a switching unit 11, an output transformer 12, a DC power source 13, a narrowband filter 15, an LCR series resonator 20, and partial resonance circuits 21 (21A, 21B).

In a switching amplifier 2 according to the second configuration example, two LCR series resonators 20A and 20B are connected in parallel between a drain terminal of an LDMOS (11A) and a drain terminal of an LDMOS (11B) and also to a primary winding 12a of the output transformer 12.

The first LCR series resonator 20A and the second LCR series resonator 20B include series circuits that are similar to the LCR series resonator 20 in the first configuration example, the first LCR series resonator 20A consisting of a series circuit formed by an inductance Lr1, a capacitance Cr1 and a resistance Rr1 and the second LCR series resonator 20B consisting of a series circuit formed by an inductance Lr2, a capacitance Cr2 and a resistance Rr2.

The first LCR series resonator 20A and the second LCR series resonator 20B set resonant frequencies of the series circuits to different values to thereby widen a frequency bandwidth in which harmonic frequency components in a load current are damped.

The first LCR series resonator 20A has a resonance frequency on a lower frequency side than a harmonic frequency n·f0 of a high-frequency output and the second LCR series resonator 20B has a resonance frequency on the higher frequency side than the harmonic frequency n·f0 of the high-frequency output with respect to a fundamental frequency f0 of the high-frequency output which is output from a secondary side of the transformer. By shifting the resonant frequencies of the parallel-connected LCR series resonators, the bandwidth of a harmonic frequency to be damped can be widened.

The configuration shown here has the two LCR series resonators connected in parallel, but the number of the parallel-connected LCR series resonators is not limited to two and may be any number. The number of the parallel-connected LCR series resonators and the frequency value of each resonance frequency are set according to the bandwidth of a harmonic frequency to be output. Control of the harmonic frequency by the LCR series resonators 20 will be described later.

### (1-3: Comparison between LCR series resonator and LC series resonator)

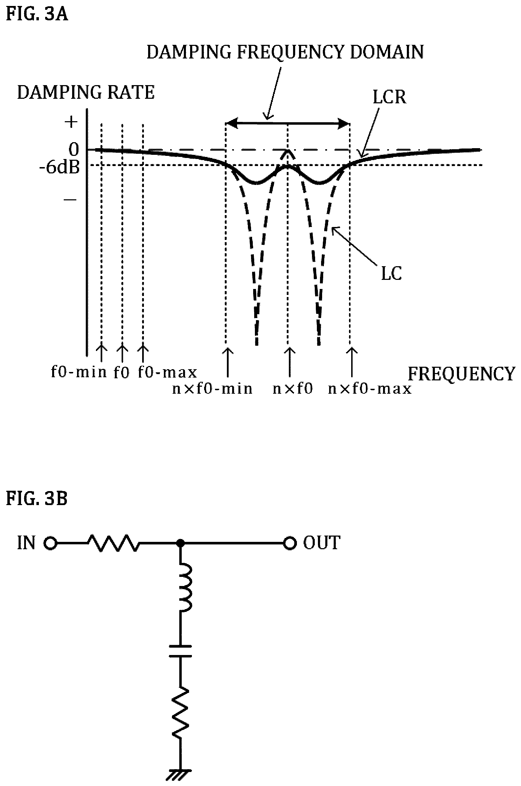

A description will be made about suppressive action on a surge voltage by the LCR series resonator in comparison with an LC series resonator. FIG. 3A shows a damping characteristic of a configuration having two LC series resonators connected in parallel. The damping characteristic in FIG. 3A represents a characteristic having two LCR series resonators connected in parallel, depicted as an equivalent circuit shown in FIG. 3B.

A solid line in FIG. 3A indicates passing characteristics of the LCR series resonators and a broken line indicates passing characteristics of the LC series resonators, all of the resonators being set to produce LC resonance at the same frequency. FIG. 3A shows the passing characteristics by damping rates with respect to the frequency, and the damping rates are larger toward the bottom of the vertical axis.

The drain-source voltage Vds contains odd harmonics, so that the resonant frequencies of the LCR series resonators and the LC series resonators are designed to resonate at a frequency that is double to four times, including approximately three times, the fundamental frequency f0 and its bandwidth (f0-min to f0-max). In FIG. 3A, a damping frequency domain is made to be a frequency range where an impedance of a series resonator appears to be 50 Ω [ohm] or less and the damping rate at which the amplitude is 1/2 is -6 dB or less.

The use of two series resonators having different frequency ranges enables the widening of the frequency band range of the resonance frequency. The LC series resonators are not appropriate to widen the frequency band range of this resonance frequency, and whereas the LCR series resonators are preferable.

According to the passing characteristic of LC series resonators having no resistance Rr indicated by the broken line in FIG. 3A, there is no damping effect at frequencies ((2 to 4)·f0) that include the third harmonics. When there is a frequency range where the damping action does not work, a frequency component of the frequency range appears in the drain-source voltage Vds, causing the generation of a surge voltage. In a case where the surge voltage exceeds a withstand voltage of an element, such as an LDMOS, it may also cause element destruction.

By contrast, according to the passing characteristics of LCR series resonator with the resistance Rr indicated by the solid line in FIG. 3A, there is an adequate damping rate also at the frequency ((2 to 4)·f0) including the third harmonics, thereby producing the damping effect in the wide frequency range.

### (2) Operation example of switching amplifier

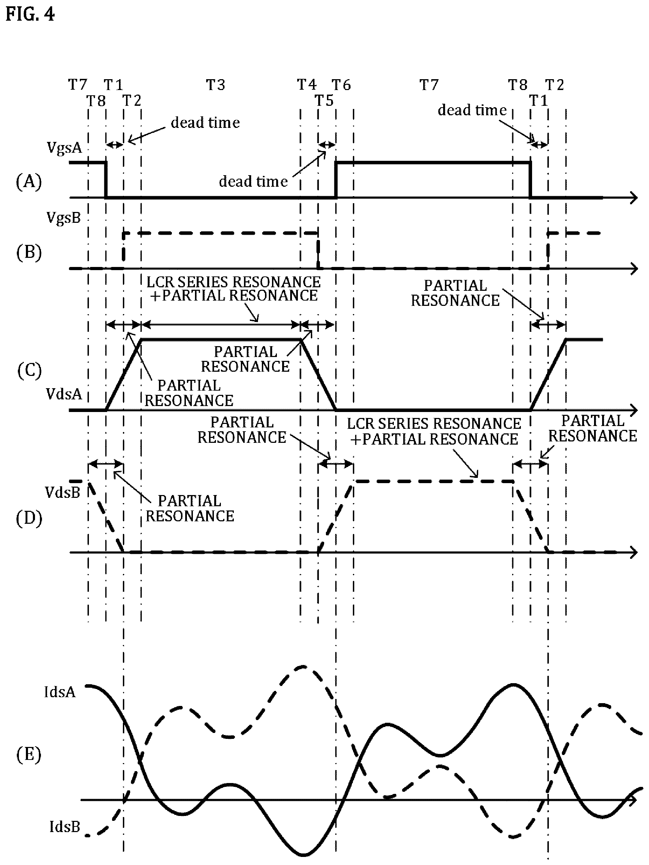

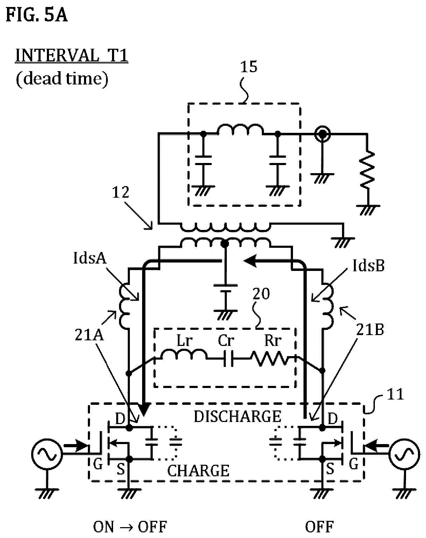

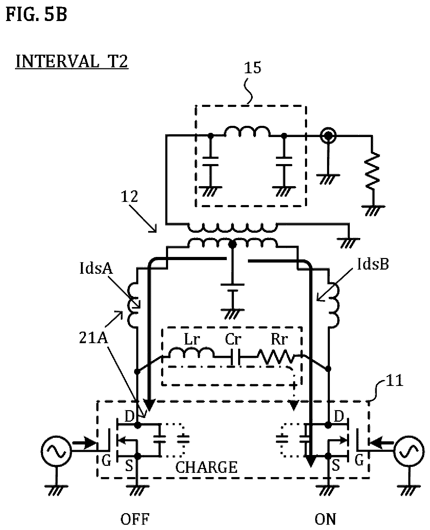

A description will be made about an operation example of the switching amplifier according to the present invention by referring to FIGS. 4 to 8. FIG. 4 shows signals at each part of the switching amplifier, and FIGS. 5 to 8 show operation examples in each section in the switching amplifier.

Figure 4A shows a gate-source voltage VgsA in the LDMOS (11A), and FIG. 4B shows a gate-source voltage VgsB in the LDMOS (11B). FIG. 4C shows a drain-source voltage VdsA in the LDMOS (11A), and FIG. 4D shows a drain-source voltage VdsB in the LDMOS (11B). FIG. 4E shows a current IdsA that flows from the LDMOS (11A) to the primary winding 12a of the output transformer 12 and a current IdsB that flows from the LDMOS (11B) to the primary winding 12a of the output transformer 12. The current IdsA is indicated with a solid line, and the current IdsB is indicated with a broken line.

In the LDMOS (11A) and the LDMOS (11B), the gate-source voltages VgsA and VgsB are turned on and off across a threshold voltage, and the gate-source voltage VgsA and gate-source voltage VgsB are switched with each other in reverse phase, thereby performing a push-pull operation. In order to avoid the two LDMOSs (11A), (11B), which form the push-pull circuit, from being in the ON state at the same time, a dead time interval is set so that both gate-source voltages are 0 V and thus the two LDMOSs (11A) and (11B) go into the OFF state at the time when each gate-source voltage switches to another.

An operation example of the LDMOS (11A) and the LDMOS (11B) will be described below by dividing time into eight intervals, intervals T1 to T8.

The intervals T1 and T5 are dead time intervals during which both of the LDMOSs (11A) and (11B) are in the OFF state. In the intervals T2, T3 and T4, the LDMOS (11A) is in the OFF state and the LDMOS (11B) is in the ON state. On the other hand, in the intervals T6, T7 and T8, the LDMOS (11A) is in the ON state and the LDMOS (11B) is in the OFF state.

The interval T1 and the interval T2 are transition intervals during which the drain-source voltage VdsA in the LDMOS (11A) increases as the LDMOS (11A) is turned off, and the interval T5 and the interval T6 are transition intervals during which the LDMOS (11B) is turned off so that the drain-source voltage VdsB in the LDMOS (11B) increases as the LDMOS (11B) is turned off.

The interval T4 and the interval T5 are transition intervals during which resonance occurs in the LDMOS (11A) while the LDMOS (11B) is turned off, so that the drain-source voltage VdsA in the LDMOS (11A) decreases. The interval T8 and the interval T1 are the transition intervals during which resonance occurs in the LDMOS (11B) while the LDMOS (11A) is turned off, so that the drain-source voltage VdsB in the LDMOS (11B) decreases.

### (Interval T1)

The interval T1 is the dead time interval during which both the LDMOS (11A) and the LDMOS (11B) are in the OFF state. In the interval T1, the LDMOS (11A) is turned from on to off.

By referring to Figure 5A, an operation state in the interval T1 will be described. When the LDMOS (11A) is turned off, the current IdsA flows in the partial resonance circuit 21A on the LDMOS (11A) side toward the LDMOS (11A) side due to energy of the primary winding 12a. The capacitance component C-A of the partial resonance circuit 21A is charged with the current IdsA. The capacitance component C-A is charged so that the drain-source voltage VdsA rises with a time constant τr that is determined by an LC constant of the capacitance component C-A and the inductance component Ls-A.

The drain-source voltage VdsA increases with the time constant τr so that the rising of the drain-source voltage VdsA can be delayed. The delay in rising of the drain-source voltage VdsA leads to a reduction of high-frequency components generated by rapid rising of the drain-source voltage VdsA, and thereby a surge voltage at the rising is suppressed.

In this case, the capacitance component C-A of the partial resonance circuit 21A is connected in series to the capacitance component C-B of the partial resonance circuit 21B. This series connection causes the reduction in the LC constant, and a rise time tr of the drain-source voltage VdsA becomes slightly shorter than a fall time tf.

By contrast, in the partial resonance circuit 21B on the LDMOS (11B) side, the current IdsB is induced by the current IdsA in the partial resonance circuit 21A to flow out from the LDMOS (11B) side toward the DC power source 13. This outflow of the current IdsB causes discharge of an electrical charge accumulated in the capacitance component C-B of the partial resonance circuit 21B.

The discharge of the capacitance component C-B causes the decrease in the drain-source voltage VdsB toward 0 V with a time constant τf that is defined by an LC constant of the capacitance component C-A and the series inductance Ls1-B.

### (Interval T2)

The interval T2 is where the LDMOS (11A) is in the OFF state and the LDMOS (11B) is in the ON state.

By referring to Figure 5B, an operation state in the interval T2 will be described. Since the LDMOS (11A) is in the OFF state, resonance occurs in the partial resonance circuit 21A on the LDMOS (11A) side, so that a charge voltage of the drain-source voltage VdsA increases with the time constant τr, whereas the current IdsA decreases.

As with the case of the interval T1, the drain-source voltage VdsA also increases with the time constant τr in the interval T2 so that the rise of the drain-source voltage VdsA is delayed. It reduces the high-frequency components generated by rapid rising of the drain-source voltage VdsA, thereby suppressing a surge voltage at the time of rising. The interval T1 and the interval T2 make the waveform at the rise of the drain-source voltage VdsA to be in a trapezoidal shape.

Since the LDMOS (11B) is in the ON state, the drain-source voltage VdsB is kept to 0 V. The current IdsB in the partial resonance circuit 21B changes from a current direction in the interval T1 and flows from the DC power source 13 toward a ground side.

### (Interval T3)

The interval T3 is where the LDMOS (11A) is in the OFF state and the LDMOS (11B) is in the ON state.

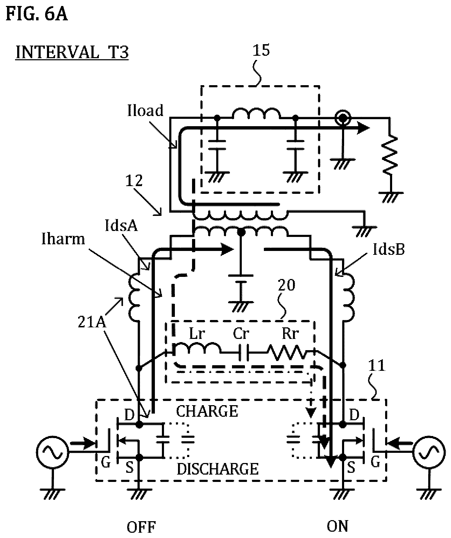

With reference to Figure 6A, a description will be made about an operation state in the interval T3. Since the LDMOS (11B) is in the ON state, the current IdsB starts flowing toward the LDMOS (11B). However, since the LDMOS (11A) is in the OFF state, the electrical charge of the capacitance component C-A of the LDMOS (11A) is maintained in the charging state, and a peak value of the drain-source voltage VdsA is maintained at a nearly constant level.

Then, the current IdsA on the LDMOS (11A) side is induced by the current IdsB to flow out from the LDMOS (11A) toward the DC power source 13 side, and the drain-source voltage VdsA oscillates due to resonance by the partial resonance circuit 21A and resonance including the inductance component of the primary winding 12a of the output transformer 12. In the middle phase in the interval T3 accompanied by resonance oscillation, the peak value of the drain-source voltage VdsA is maintained nearly constant, and the surge voltage generated due to rapid change in the load current is suppressed by partial resonance.

In the later phase of the interval T3, the electrical charge of the capacitance component C-A of the LDMOS (11A) is changed into a discharging state, and the peak value of the drain-source voltage VdsA tends to decrease.

As the current IdsB flows through the primary winding 12a, a load current Iload with harmonic frequency components flows through the secondary winding 12b of the output transformer 12. The load current Iload passes through the narrowband filter 15 and flows from the output end 16 into the load 17. On the other hand, the harmonic frequency components are reflected by the narrowband filter 15 and flows into the LCR series resonator 20 via the output transformer 12, and then flows into the LDMOS (11B) in the ON state. At this time, the harmonic frequency components are reduced by the resistance Rr in the LCR series resonator 20, thereby suppressing the surge voltage generated by the harmonic frequency components.

### (Interval T4)

As with the interval T3, the interval T4 is where the LDMOS (11A) is in the OFF state and the LDMOS (11B) is in the ON state.

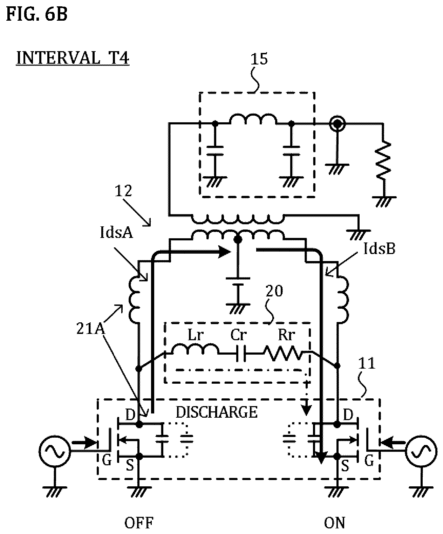

A description will be made about an operation state in the interval T4 by referring to FIG. 6B. In the interval T4, the drain-source voltage VdsA tends, following the later phase in the interval T3, to decrease due to the resonance including the inductance component of the primary winding 12a of the output transformer 12, and the surge voltage is suppressed by the resonance of the partial resonance circuit 21A.

### (Interval T5)

The interval T5 is a dead time interval during which both the LDMOS (11A) and the LDMOS (11B) are in the OFF state, the LDMOS (11B) being turned from on to off.

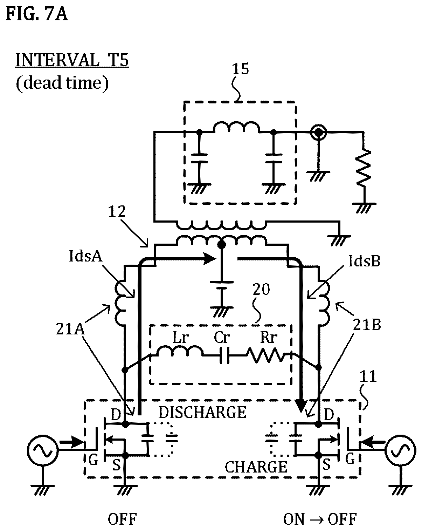

By referring to Figure 7A, an operation state in the interval T5 will be described. When the LDMOS (11B) is turned off, the current IdsB flows in the partial resonance circuit 21B toward the LDMOS(11B) side due to energy of the primary winding 12a.

In the partial resonance circuit 21A on the LDMOS (11A) side, the current IdsA is induced by the current IdsB in the partial resonance circuit 21B to flow out from the LDMOS (11A) side toward the DC power source 13. This outflow of the current IdsA causes discharge of the electrical charge accumulated in the capacitance component C-A of the partial resonance circuit 21A. The discharge of the capacitance component C-A causes the decrease in the drain-source voltage VdsA toward 0 V with the time constant τf.

By contrast, the capacitance component C-B of the partial resonance circuit 21B is charged with the current IdsB. The charge of the capacitance component C-B causes the increase in the drain-source voltage VdsB with the time constant τr defined by the LC constant of the capacitance component C-B and the inductance component Ls-B.

The increase in the drain-source voltage VdsB with the time constant τr can delay the rise of the drain-source voltage VdsB. The delay of the rise of the drain-source voltage VdsB reduces the high-frequency components generated by the rapid rise of the drain-source voltage VdsB, thereby suppressing the surge voltage at the time of rising.

In this case, the capacitance component C-B of the partial resonance circuit 21B is connected in series to the capacitance component C-A of the partial resonance circuit 21A. This series connection reduces the LC constant, and a rise time tr of the drain-source voltage VdsB becomes slightly shorter than a fall time tf.

### (Interval T6)

The interval T6 is where the LDMOS (11A) is in the ON state and the LDMOS (11B) is in the OFF state.

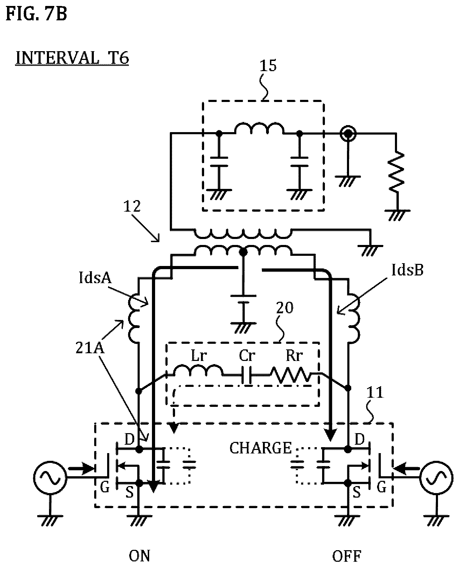

An operation state in the interval T6 will be described by referring to FIG. 7B. Since the LDMOS (11A) is in the ON state, the drain-source VdsA is kept to 0 V. The current IdsA in the partial resonance circuit 21A changes from a current direction in the interval T5 and flows from the DC power source 13 toward the ground side.

Since the LDMOS (11B) is in the OFF state, resonance occurs in the partial resonance circuit 21B on the LDMOS (11B) side, so that a charge voltage of the drain-source voltage VdsB increases with the time constant τr, whereas the current IdsB decreases.

As with the case of the interval T5, the drain-source voltage VdsB also increases with the time constant τr in the interval T6 so that the rise of the drain-source voltage VdsB is delayed. It reduces the high-frequency components generated by the rapid rising of the drain-source voltage VdsB, thereby suppressing the surge voltage at the time of rising. The interval T5 and the interval T6 make the waveform to be in a trapezoidal shape at the rise of the drain-source voltage VdsB.

### (Interval T7)

The interval T7 is where the LDMOS (11A) is in the ON state and the LDMOS (11B) is in the OFF state.

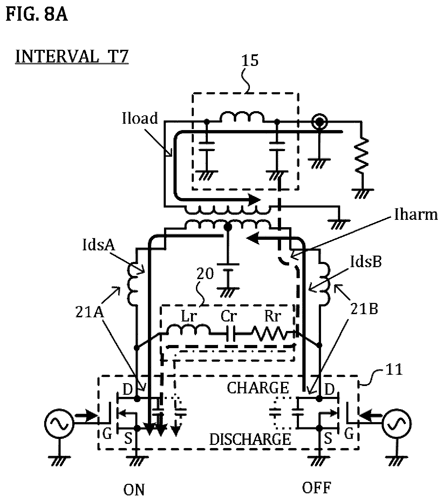

By referring to Figure 8A, a description will be made about an operation state in the interval T7. Since the LDMOS (11A) is in the ON state, the current IdsA starts flowing toward the LDMOS (11A). However, since the LDMOS (11B) is in the OFF state, the electrical charge of the capacitance component C-B of the LDMOS (11B) is maintained in the charging state, and the peak value of the drain-source voltage VdsB is maintained nearly constant.

Then, the current IdsB on the LDMOS (11B) side is induced by the current IdsA to flow out from an LDMOS (11AB) toward the DC power source 13 side, and the drain-source voltage VdsB oscillates due to the resonance by the partial resonance circuit 21B and the resonance including the inductance component of the primary winding 12a of the output transformer 12. In the middle phase in the interval T7 accompanied by resonance oscillation, the peak value of the drain-source voltage VdsB is maintained nearly constant, and the surge voltage generated due to the rapid change in the load current is suppressed by partial resonance.

In the later phase of the interval T7, the electrical charge of the capacitance component C-B of the LDMOS (11B) is changed into a discharging state, and the peak value of the drain-source voltage VdsB tends to decrease. As the current IdsA flows through the secondary winding 12b, the load current Iload with harmonic frequency components flows through the primary winding 12a. The load current Iload passes through the narrowband filter 15 and flows from the output end 16 into the load 17. On the other hand, the harmonic frequency components are reflected by the narrowband filter 15 and flow into the LCR series resonator 20 via the output transformer 12, and then flow into the LDMOS (11A) in the ON state. At this time, the harmonic frequency components are reduced by the resistance Rr in the LCR series resonator 20, thereby suppressing the surge voltage generated by the harmonic frequency components.

### (Interval T8)

The interval T8 is where the LDMOS (11A) is in the ON state and the LDMOS (11B) is in the OFF state, as with the case of the interval T7.

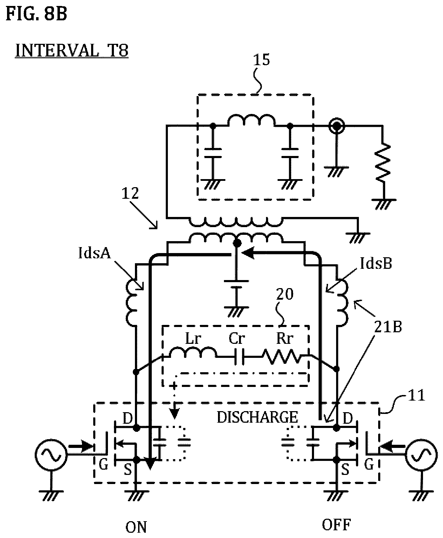

A description will be made about an operation state in the interval T8 by referring to FIG. 8B. In the interval T8, the drain-source voltage VdsB tends, following the later phase in the interval T7, to decrease due to the resonance including the inductance component of the primary winding 12a of the output transformer 12, and the surge voltage is suppressed by the resonance of the partial resonance circuit 21B.

### (3) Trapezoidal waveform

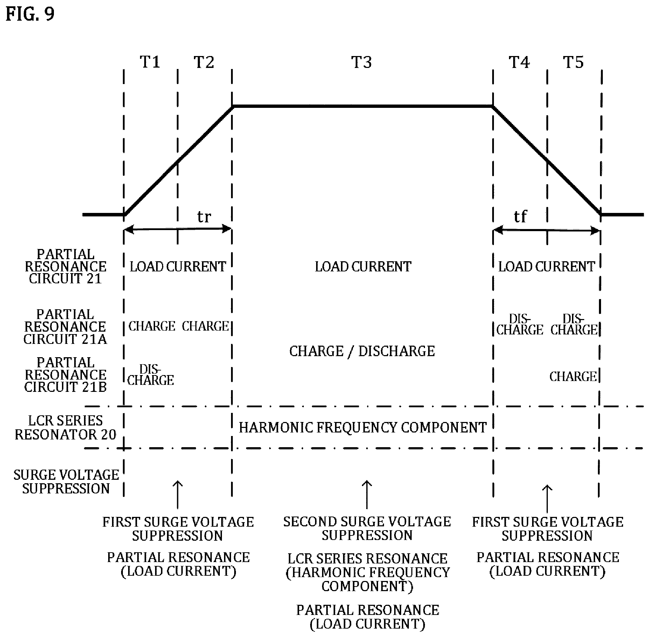

A description will be made about a trapezoidal waveform of a drain-source voltage in each switching element according to the present invention. The trapezoidal waveform shown in FIG. 9 represents the drain-source voltage VdsA in the LDMOS (11A) between the interval T1 to the interval T5, and shows two types of resonance produced by the partial resonance circuit 21 and the LCR series resonator 20 as well as surge voltage suppression by the two types of resonance.

### (Suppression of first surge voltage)

The partial resonance circuit 21 reduces the high-frequency components included in the load current in the interval T1 to the interval T5 and the interval T6 to the interval T8, thereby suppressing a first surge voltage generated by the high-frequency components.

The load current flows as the current IdsA in the partial resonance circuit 21A while flowing as the current IdsB in the partial resonance circuit 21B.

In the intervals T1 and T2, the current IdsA charges the capacitance component C-A of the partial resonance circuit 21A in both the interval T1 and the interval T2, and the current IdsB discharges the capacitance component C-B of the partial resonance circuit 21B in the interval T1.

In the interval T3, the current IdsA brings the capacitance component C-A of the partial resonance circuit 21A from the charging state into the discharging state.

In the intervals T4 and T5, the current IdsA discharges the capacitance component C-A of the partial resonance circuit 21A in both the interval T1 and the interval T2, and the current IdsB charges the capacitance component C-B of the partial resonance circuit 21B in the interval T5.

In the intervals T1, T2 and the intervals T4, T5, the partial resonance circuit 21 conducts charging and discharging to make the waveforms at the rising and falling edges of the drain-source voltage Vds to be in the sloped trapezoidal shape with the rise time tr and the fall time tf, so that the high-frequency components contained in the current Ids are reduced to suppress the first surge voltage generated by the high-frequency components. In the interval T3, the partial resonance circuit 21 reduces the high-frequency components contained in the current Ids with the resistance of a load impedance in association with a resonance action, thereby suppressing the first surge voltage generated by the high-frequency components.

### (Suppression of second surge voltage)

In the interval T3, the partial resonance circuit 21 reduces the high-frequency components contained in the load current to suppress a second surge voltage that is generated by the harmonic frequency components.

In the interval T3, the load current flows on a second side of the output transformer 12. The load current contains frequency components of a fundamental frequency f0 and frequency components of a harmonic frequency n·f0. The LCR series resonator 20 sets a resonance frequency to correspond to the harmonic frequency n·f0 so as to take in the frequency components of the harmonic frequency n·f0 that is reflected by the narrowband filter, and damps it by consuming in the resistance Rr. In this way, the LCR series resonator 20 suppresses the second surge voltage generated by the harmonic frequency components.

### (4) Wideband

A description will be made about widening of a bandwidth of an output from a switching amplifier according to the present invention. The following description indicates a wideband in partial resonance and a wideband in an LCR series resonator.

### (Wideband by partial resonance)

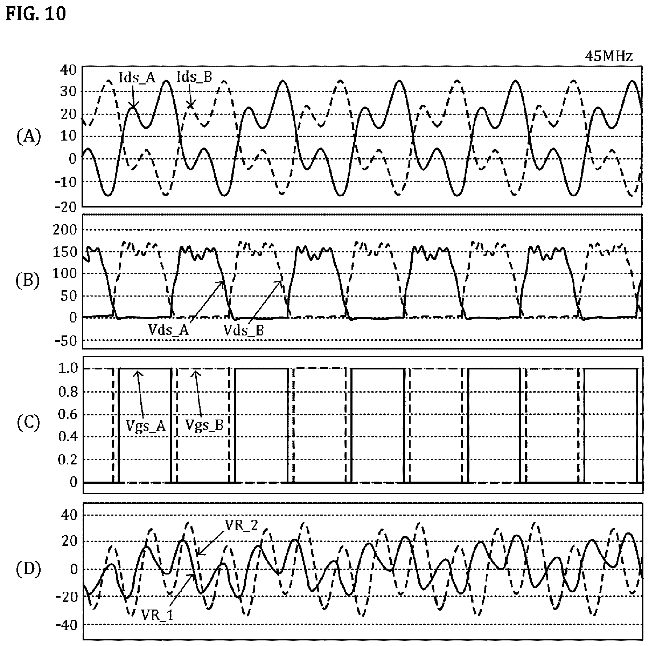

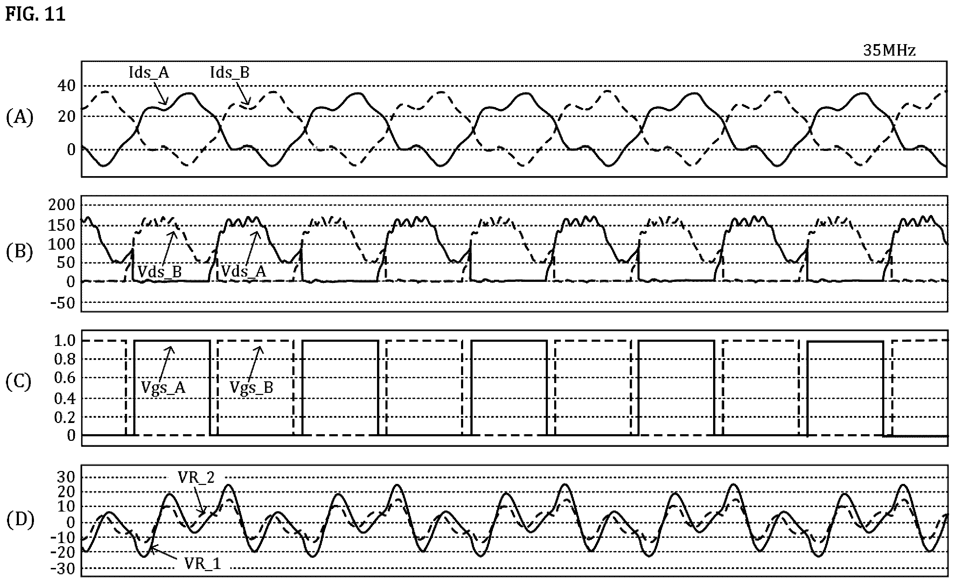

Widening of an output by partial resonance will be described by referring to FIGS. 10 and 11. FIG. 10 shows an example of a waveform when the fundamental frequency f0 is 45 MHz. FIG. 11 shows an example of a waveform when the fundamental frequency f0 is 35 MHz.

Figures 10A and 11A show currents IdsA and IdsB, respectively, FIGS. 10B and 11B show drain-source voltages VdsA and VdsB, respectively, FIGS. 10C and 11C show gate-source voltages VgsA and VgsB, respectively, and FIGS. 10D and 11D show voltages VR1 and VR2 of the resistance Rr of the LCR series resonator.

The resonance frequency of the partial resonance circuit is designed to be in the range of 1 to 3 times the fundamental frequency f0, preferably approximately 1.5 to 2.5 times the fundamental frequency. When the resonance frequency of the partial resonance circuit is set within the above-described frequency range, it is desirable that a total loss, which takes into consideration switching losses and an increase in loss opportunity due to an increase in the frequency, is suitable as an output of the switching amplifier even if the fundamental frequency f0 is varied.

The example of the waveform in FIG. 10 and the example of the waveform in FIG. 11 illustrate that when the fundamental frequency f0 is 40 MHz, the frequency is variable between 35 MHz and 45 MHz.

When the frequency is 35 MHz, a slight increase is observed in the waveform of a residual drain-source voltage Vd right before the LDMOS is turned from OFF to ON due to partial resonance. However, even though this voltage increase causes the increase in the switching loss in one cycle, an influence on the total loss is small because the frequency is low.

By contrast, when the frequency is 45 MHz, the gate-source voltage Vgs of the LDMOS is applied near the lowest point of the drain-source voltage Vds, so that zero voltage switching (ZVS) is carried out to thereby reduce the switching loss in one cycle. Although the frequency increases, the influence on the total loss is small because of the reduction in the switching loss. In a case where the frequency of the partial resonance is more than three times the fundamental frequency f0, the residual drain-source voltage Vds increases further, causing overall decrease in efficiency.

### (Wideband by LCR series resonator)

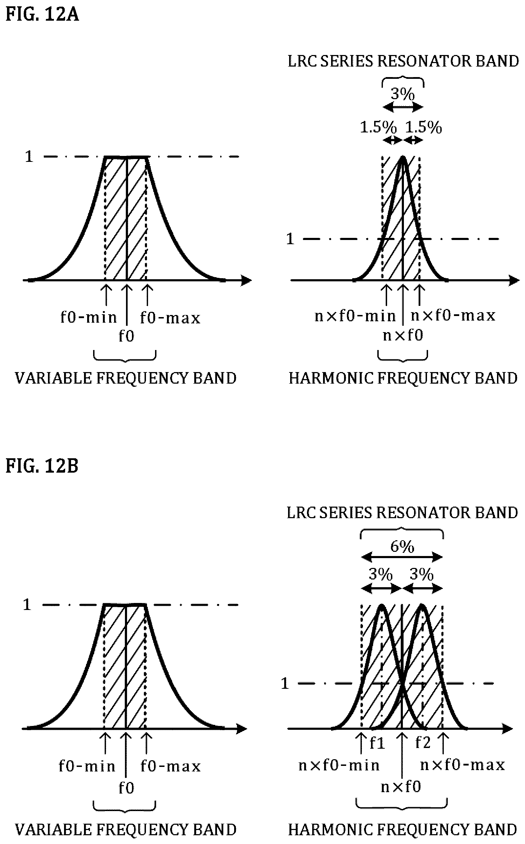

A description will be made about widening the bandwidth of an output by the LCR series resonator by referring to FIG. 12. FIG. 12 shows resonance curves represented by an admittance or electric current.

Figure 12A shows a resonance curve in a case of configuring an LCR series resonator by a single series circuit, and FIG. 12B shows a resonance curve in a case of configuring the LCR series resonator by two series circuits that are connected in parallel to each other.

The resonance curve on the left of Figure 12A indicates a passband of a variable frequency band, in which a lower limit frequency f0-min and an upper limit frequency f0-max for the fundamental frequency f0 are set according to frequencies that are close to 1 which is the maximum value of the resonance curve.

With respect to the passband of the variable frequency band, the curve on the right of FIG. 12A is a resonance curve of the series circuit in a harmonic frequency band in the case of configuring the LCR series resonator by a single series circuit. The resonance curve of the series circuit in the harmonic frequency band is set within a frequency range in which a lower limit frequency n·f0-min and an upper limit frequency n·f0-max for a harmonic frequency n·f0 (n is an integer) are set so that the series resonator of the series circuit in the harmonic frequency band is 50 Ω [ohm] or less (this is taken as reference 1) and an electric current that flows through the series resonator is one or more times.

The lower limit frequency n·f0-min and the upper limit frequency n·f0-max set the frequency range in the harmonic frequency band. For example, this frequency range is set to be ±1.5 % or more and 3 % or more in total with respect to the harmonic frequency n·f0. By setting the harmonic frequency band in such a way, even when the frequency varies within the variable frequency band, the admittance or electric current can be one or more times for the base of 50 Ω [ohm], and thereby higher losses, or damping, can be expected and the band can be widened.

The curve on the left of Figure 12B indicates the passband of the variable frequency band as with the curve on the left of FIG. 12A, in which the lower limit frequency f0-min and the upper limit frequency f0-max for the fundamental frequency f0 are set according to frequencies that are close to 1 which is the maximum value of the resonance curve.

With respect to the resonance curve of the variable frequency band, two curves on the right of FIG. 12B are resonance curves of a series circuit in a harmonic frequency band in the case of configuring the LCR series resonator by two series circuits. These resonance curves of the series circuit in the harmonic frequency band are formed by using two resonance curves of the series circuit in the harmonic frequency band on the right of FIG. 12A, in which center frequencies f1 and f2 are shifted.

The resonance curve of the series circuit in one harmonic frequency band is set to the center frequency f1 that is shifted toward the low frequency side, and the resonance curve of the series circuit in the other harmonic frequency band is set to the center frequency f2 that is shifted toward the high frequency side. The two resonance curves set a frequency characteristic so that an electric current flowing through the combined series resonators in the harmonic frequency band, which is set by the lower limit frequency f0-min and the upper limit frequency f0-max for the harmonic frequency n·f0 where n is an integer, is one or more times.

The lower limit frequency n·f0-min and the upper limit frequency n·f0-max, which are set as the frequency range in the harmonic frequency band, are set to be ±3 % or more and 6 % or more in total with respect to the harmonic frequency n·f0, for instance. The use of the two series circuits can widen the frequency range in the harmonic frequency band. By setting the harmonic frequency band in such a way, even when the frequency varies within the variable frequency band, the admittance or electric current can be one or more times for the base of 50 Ω [ohm], and thereby higher losses, or damping, can be expected and the band can be widened.

### (Frequency band of partial resonance and frequency band of high impedance)

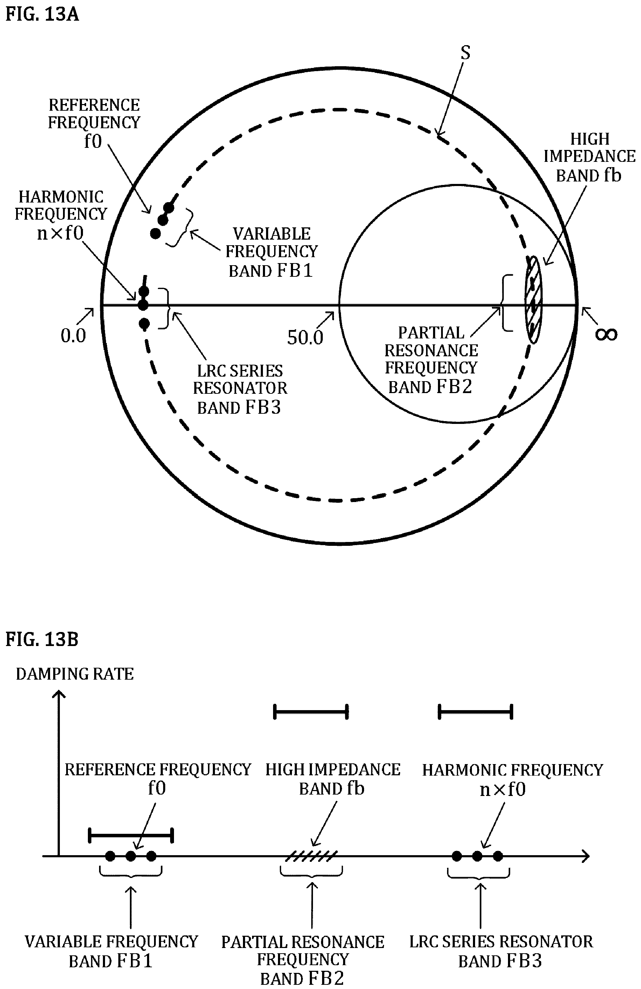

A description will be made about a relation between a frequency band of a partial resonance and a frequency band of a high impedance by referring to FIG. 13. FIG. 13A shows a Smith Chart, and FIG. 13B shows a frequency characteristics diagram of a damping rate.

The Smith Chart in Figure 13A shows a constant SWR circle S that indicates a reflection state with a load. When a frequency is swept, an impedance is indicated with a trajectory moving clockwise from the low frequency side to the high frequency side on the constant SWR circle S. On the constant SWR circle S shown in FIG. 13A, there is a high impedance band fb, in which the impedance gets higher, between the fundamental frequency f0 and the harmonic frequency n·f0 in the frequency range from the fundamental frequency f0 to the harmonic frequency n·f0.

Consequently, with the frequency range from the fundamental frequency f0 to the harmonic frequency n·f0 as an output frequency range, a switching amplifier that makes the frequency variable has two frequencies and frequency ranges, namely the high impedance band fb and the harmonic frequency n·f0, where the impedance becomes high. The high impedance causes the generation of a surge voltage.

In order to suppress the surge voltage in the high impedance band fb, the impedance is decreased in the frequency range close to the high impedance band fb. The present invention decreases the impedance by setting a partial resonance frequency band FB2 with the partial resonance circuit, thereby suppressing the surge voltage in the high impedance band fb.

In order to suppress the surge voltage in the frequency range centered on the harmonic frequency n·f0, the impedance in this frequency range is decreased. The present invention decreases the impedance by setting an LCR series resonator band FB3 with the LCR series resonator, thereby suppressing the surge voltage in the frequency range centered on the harmonic frequency n·f0.

Figure 13B shows the Smith Chart in FIG. 13A with frequency characteristics of the damping rate. The partial resonance frequency band FB2 corresponds to the high impedance band fb, and the LCR series resonator band FB3 corresponds to the frequency range centered on the harmonic frequency n·f0. The damping rate is set to be high in the partial resonance frequency band FB2 and the LCR series resonator band FB3 to thereby suppress the surge voltage.

### [INDUSTRIAL APPLICABILITY]

The switching amplifier of the present invention can be applied to a high-frequency power supply (RF generator) which is used for semiconductor manufacturing equipment, liquid crystal panel manufacturing equipment and others.

### [REFERENCE SIGNS LIST]

- 1, 2: Switching Amplifier
- 10A: Signal Source
- 10B: Signal Source
- 11: Switching Unit
- 12: Output Transformer
- 12a: Primary Winding
- 12b: Secondary Winding
- 13: DC Power Source
- 14: Push-Pull Circuit
- 15: Narrowband Filter
- 16: Output End
- 17: Load
- 20, 20a, 20b: LCR Series Circuit
- 21, 21A, 21B: Partial Resonance Circuit
- 101a, 101b: Switching Amplifier
- 110A, 110B: Signal Source
- 111: Switching Unit
- 111A, 111B: Switching Element
- 112: Output Transformer
- 112a: Primary Winding
- 112b: Secondary Winding
- 113: DC Power Source
- 114: Push-Pull Circuit
- 115: Narrowband Filter
- 116: Output End
- 117: Load
- C, C-A, C-B: Capacitance Component
- Coss-A, Coss-B: Parasitic Capacitance
- Cp-A, Cp-B: Additional Capacitance
- Cr, Cr1, Cr2: Capacitance
- Ctotal-A, Ctotal-B: Total Capacitance
- FB2: Partial Resonance Frequency Band
- FB3: LCR Series Resonator Band
- Ids, IdsA, IdsB: Electric Current
- Iload: Load Current
- Lline-A, Lline-B: Wiring Inductance
- Lr, Lr1, Lr2: Inductance
- Lleak: Leakage Inductance
- Ls, Ls-A, Ls-B: Inductance Component
- Ls1-A, Ls1-B: Series Inductance
- Pg: Gate Signal
- R1: Primary Resistance Component
- Rr, Rr1, Rr2: Resistance
- S: Constant SWR Circle
- T1, T2, T3, T4, T5, T6, T7, T8: Interval
- Vds, VdsA, VdsB: Drain-Source Voltage
- Vgs, VgsA, VgsB: Gate-Source Voltage
- f0: Fundamental Frequency
- f0-max: Upper Limit Frequency
- f0-min: Lower Limit Frequency
- f1, f2: Center Frequency
- fb: High Impedance Band
- τf, τr: Time Constant

## Claims

1. A switching amplifier, comprising:
a transformer-coupled push-pull circuit that consists of a pair of switching elements alternately switched on and off by using input signals having phases opposite to each other, and an output transformer on which both ends a primary winding which inputs output signals of the switching elements and a secondary winding which draws out the output signals having phases opposite to each other are connected and in which a midtap of the primary winding is connected to an external power supply;
a narrowband filter that is connected to an output end of the secondary winding of the output transformer;
a pair of partial resonance circuits that consist of an inductance component on a drain side of each switching element and a capacitance component between the drain and a source of each switching element; and
an LCR series resonator that consists of a series circuit of an inductance, a capacitance, and a resistance connected between the drain ends of the switching elements.

2. The switching amplifier according to claim 1, wherein the inductance component included in each partial resonance circuit is either a series inductance connected in series between each switching element and one end of the transformer, a leakage inductance of the output transformer or a wiring inductance between each switching element and one end of the transformer, or any combinations of them, and
the capacitance component included in each partial resonance circuit is an output parasitic capacitance of the switching element, or a total capacitance of the output parasitic capacitance of the switching element and an additional capacitance connected to the switching element in parallel.

3. The switching amplifier according to claim 1, wherein in a range from a fundamental frequency f0 to a third harmonic frequency (3·f0) of a high-frequency output that is output from a secondary side of the output transformer,
a resonance frequency of each partial resonance circuit is set such that an impedance is decreased in a frequency range in which the impedance is increased by the partial resonance circuit, and
uses time constants of a rising edge and a falling edge of a drain-source voltage of each switching element as setting values.

4. The switching amplifier according to claim 1, wherein with respect to the fundamental frequency f0 of the high-frequency output from the secondary side of the output transformer,
a resonance frequency of the LCR series resonator is a harmonic frequency n·f0, where n is an integer, and
the resonance frequency has its bandwidth set in a frequency range of (n·f0-min to n·f0-max) depending on a variable frequency range (f0-min to f0-max) of the fundamental frequency f0.

5. The switching amplifier according to claim 1, comprising multiple LCR series resonators that are connected in parallel to one another with different resonance frequencies.

6. The switching amplifier according to claim 5, comprising with respect to the fundamental frequency f0 of the high-frequency output from the secondary side of the output transformer:
a first LCR series resonator that has a resonance frequency on a lower frequency side than the harmonic frequency n·f0 of the high-frequency output; and
a second LCR series resonator that has a resonance frequency on a high frequency side than the harmonic frequency n·f0 of the high-frequency output.

7. The switching amplifier according to any one of claims 1 to 6, wherein each switching element is a DMOS.
